## Europäisches Patentamt
## European Patent Office
## Office européen des brevets

(11) Veröffentlichungsnummer: **0 519 432 A2**

# EUROPÄISCHE PATENTANMELDUNG

(21) Anmeldenummer: **92110242.2**

(22) Anmeldetag: **17.06.92**

(51) Int. Cl.5: **C11D 7/50**, H05K 3/26, C23G 5/028

(30) Priorität: **21.06.91 DE 4120507**

(43) Veröffentlichungstag der Anmeldung: **23.12.92 Patentblatt 92/52**

(84) Benannte Vertragsstaaten: **BE DE DK ES FR GB IT NL**

(71) Anmelder: **HOECHST AKTIENGESELLSCHAFT Postfach 80 03 20 W-6230 Frankfurt am Main 80(DE)**

(72) Erfinder: **Robeck, Horst Am Pfingstbrunnen 14 W-6238 Hofheim am Taunus(DE)**
Erfinder: **Deger, Hans-Matthias, Dr. Herrnpfad 10 W-6238 Hofheim am Taunus(DE)**

(54) **Azeotropartiges Gemisch aus 2-Propanol und 1H-Perfluorhexan.**

(57) Die Erfindung betrifft ein azeotropartiges Gemisch, das etwa 8-12 Gew.-% 2-Propanol und etwa 88-92 Gew.-% 1H-Perfluorhexan enthält, sowie ein Verfahren zur Reinigung von elektronischen Bauteilen, insbesondere gelöteten Leiterplatten oder gedruckten Schaltungen mit Hilfe dieses Gemisches.

EP 0 519 432 A2

Es ist Stand der Technik, zum Reinigen von gelöteten Leiterplatten und anderen elektronischen Bauteilen Gemische aus 1,1,2-Trichlor-1,2,2-trifluorethan (R 113) und Alkoholen wie Methanol, Ethanol oder 2-Propanol einzusetzen (GB-PS 1 026 003, GB-PS 1 399 867). Aus US-PS 3 960 746 ist eine azeotropartige Mischung aus R 113, Methanol und Nitromethan für denselben Zweck bekannt. Da jedoch die FCKW im Verdacht stehen, die Ozonschicht zu schädigen, ist es notwendig, auf diese Stoffklasse zu verzichten.

Für den Bereich der Elektronik-Industrie, insbesondere zum Reinigen von Leiterplatten nach dem Lötvorgang, werden zur Zeit verschiedene Systeme auf wäßriger Basis und auf Basis nichthalogenierter organischer Lösemittel diskutiert. Bei wäßrigen Reinigungsmitteln ist es jedoch schwierig, die richtige Tensid/Komplexbildner-Kombination zu finden. Auch muß das System an die mechanische Behandlung wie Spülen, Bürsten, Dampfstrahl, Ultraschall angepaßt werden. Bei der SMT (Surface Mount Technology)-Technik scheiden wäßrige Reinigungssysteme häufig aus, da sich das Wasser nur schwer wieder entfernen läßt.

Bei Einsatz nichthalogenierter organischer Lösemittel, wie Benzin, Alkohole, Terpene oder Ester ist aufgrund der Brennbarkeit und der Explosivität dieser Substanzen eine explosionsgeschützte Ausführung der Anlage erforderlich, so daß aus ökonomischen Gründen eine Verwendung in Oberflächenbehandlungsanlagen nur in wenigen Fällen infrage kommt.

In den nicht vorveröffentlichten deutschen Patentanmeldungen P 4 002 120.3 und P 4 013 369.9 werden azeotropartige Lösemittelgemische aus 1,4-Dihydroperfluorbutan und Methanol bzw. aus 2,2,2-Trifluorethyl-1,1,2,2-tetrafluorethylether und Ethanol beschrieben, welche für die Reinigung von elektrischen und elektronischen Bauteilen geeignet sind.

Überraschenderweise wurde nun gefunden, daß 1H-Perfluorhexan $CF_3$-$(CF_2)_4$-$CF_2H$ mit 2-Propanol ein azeotropartiges Lösungsmittelgemisch bildet, welches hervorragend zur Reinigung von elektronischen Bauteilen, insbesondere gelöteten Leiterplatten oder gedruckten Schaltungen, vor allem zur Entfernung von Lötflußmitteln geeignet ist.

Ein Gegenstand der Erfindung ist ein azeotropartiges Gemisch, das etwa 8-12 Gew.-% 2-Propanol und etwa 88-92 Gew.-% 1H-Perfluorhexan enthält. Vorzugsweise enthält das Gemisch 8,5-11,0 Gew.-% 2-Propanol, insbesondere 9,0-10,0 Gew.-% 2-Propanol, wobei der Rest jeweils 1H-Perfluorhexan ist. Ein weiterer Gegenstand der Erfindung ist ein Verfahren zur Reinigung von elektronischen Bauteilen, insbesondere gelöteten Leiterplatten oder gedruckten Schaltungen, das dadurch gekennzeichnet ist, daß man die Bauteile mit einem azeotropartigen Gemisch wäscht, das etwa 8-12 Gew.-% 2-Propanol und 88-92 Gew.-% 1H-Perfluorhexan enthält. Vorzugsweise verwendet man ein Gemisch, das 8,5-11,0 Gew.-% 2-Propanol, insbesondere 9,0-10,0 Gew.-% 2-Propanol enthält, wobei der Rest jeweils im wesentlichen 1H-Perfluorhexan ist.

Ein besonders bevorzugtes Lösungsmittelgemisch enthält 90,7 Gew.-% 1H-Perfluorhexan und 9,3 Gew.-% 2-Propanol und hat einen Siedepunkt bei 1 bar von 63,4 °C.

Bei dem erfindungsgemäßen Gemisch aus 2-Propanol und 1H-Perfluorhexan ist die Zusammensetzung des Dampfes identisch oder im wesentlichen identisch mit der Zusammensetzung der Flüssigkeit, d.h. beim Verdampfen ändert sich die Zusammensetzung des Gemisches nicht oder nicht wesentlich. Das erfindungsgemäße Lösungsmittelgemisch hat den weiteren Vorteil, daß es kein Chlor enthält, und damit keine Ozonschädigung bewirkt. Außerdem ist es nicht brennbar und kann in den üblichen Ultraschall-, Tauch- und Bürstenwaschanlagen eingesetzt werden.

Beispiel 1

Ein glasfaserverstärktes Basismaterial für Leiterplatten auf Polyesterbasis wurde mit einem handelsüblichen Lötflußmittel (Zeva C 20-200 der Firma Zevatron, Hauptbestandteil Kolophonium, daneben Aktivatoren) bestrichen und 18 Stunden bei 60 °C im Trockenschrank getrocknet. Anschließend wurde das Material mit einem Gemisch aus 1H-Perfluorhexan (90,7 Gew.-%) und 2-Propanol (9,3 Gew.-%) unter Anwendung von Ultraschall gewaschen. Die Einwirkzeit betrug 30-60 Sekunden, das Flußmittel wurde vollständig entfernt.

Beispiel 2

Man ging vor wie in Beispiel 1, nur daß man ein anderes Lötflußmittel benutzte (Zeva C 30-300 der Firma Zevatron), welches wiederum als Hauptbestandteil Kolophonium neben Aktivatoren enthielt. Nach einer Einwirkzeit von 30-60 Sekunden war das Flußmittel vollständig entfernt. Bei den herkömmlichen Gemischen aus 1,1,2-Trichlor-1,2,2-trifluorethan mit Methanol, Ethanol oder 2-Propanol betragen die Behandlungszeiten dagegen je nach Flußmittel zwischen 60 und 90 Sekunden. Außerdem lassen sich ionische Rückstände mit dem Azeotrop besser entfernen als mit den herkömmlichen Gemischen.

Beispiel 3

Beispiel 3 wurde wie Beispiel 1 durchgeführt, nur daß als Lötflußmittel das Flußmittel GR8 der Fa. Ersa (Hauptbestandteil Kollophonium, daneben Aktivatoren) verwendet wurden. Nach einer Einwirkzeit von 30-60 Sekunden war das Flußmittel vollständig entfernt.

**Patentansprüche**

1.  Azeotropartiges Gemisch, das etwa 8-12 Gew.-% 2-Propanol und etwa 88-92 Gew.-% 1H-Perfluorhexan enthält.

2.  Azeotropartiges Gemisch nach Anspruch 1, das etwa 8,5-11,0 Gew.-% 2-Propanol und etwa 89,0-91,5 Gew.-% 1H-Perfluorhexan enthält.

3.  Azeotropartiges Gemisch nach Anspruch 1, das etwa 9,0-10,0 Gew.-% 2-Propanol und etwa 90,0-91,0 Gew.-% 1H-Perfluorhexan enthält.

4.  Verfahren zur Reinigung von elektronischen Bauteilen, insbesondere gelöteten Leiterplatten oder gedruckten Schaltungen, dadurch gekennzeichnet, daß man die Bauteile mit einem azeotropartigen Gemisch nach einem der Ansprüche 1 bis 3 wäscht.

5.  Verfahren zur Entfernung von Lötflußmitteln, gekennzeichnet durch eine Wäsche mit einem azeotropartigen Gemisch nach einem der Ansprüche 1 bis 3.

**Patentansprüche für folgenden Vertragsstaat : ES**

1.  Verfahren zur Reinigung von elektronischen Bauteilen, insbesondere gelöteten Leiterplatten oder gedruckten Schaltungen, dadurch gekennzeichnet, daß man die Bauteile mit einem azeotropartigen Gemisch wäscht, das etwa 8-12 Gew.-% 2-Propanol und etwa 88-92 Gew.-% 1H-Perfluorhexan enthält.

2.  Verfahren nach Anspruch 1, dadurch gekennzeichnet, daß das azeotropartige Gemisch etwa 8,5-11,0 Gew.-% 2-Propanol und etwa 89,0 - 91,5 Gew.-% 1H-Perfluorhexan enthält.

3.  Verfahren nach Anspruch 1, dadurch gekennzeichnet, daß das azeotrope Gemisch etwa 9,0-10,0 Gew.-% 2-Propanol und etwa 90,0-91,0 Gew.-% 1H-Perfluorhexan enthält.

4.  Verfahren zur Entfernung von Lötflußmitteln, gekennzeichnet durch eine Wäsche mit einem azeotropartigen Gemisch, das etwa 8-12 Gew.-% 2-Propanol und etwa 88-92 Gew.-% 1H-Perfluorhexan enthält.

5.  Verfahren nach Anspruch 4, dadurch gekennzeichnet, daß das azeotrope Gemisch etwa 8,5-11,0 Gew.-% 2-Propanol und etwa 89,0-91,5 Gew.-% 1H-Perfluorhexan enthält.

6.  Verfahren nach Anspruch 4, dadurch gekennzeichnet, daß das azeotrope Gemisch etwa 9,0-10,0 Gew.-% 2-Propanol und etwa 90,0-91,0 Gew.-% 1H-Perfluorhexan enthält.